# EUROPEAN PATENT SPECIFICATION

(11) **EP 3 476 973 B1**
(45) Date of publication and mention of the grant of the patent: **22.04.2026**
(21) Application number: 17198366.1
(22) Date of filing: 25.10.2017
(51) Int. Cl.: C23C 16/44, B29C 64/371, B22F 10/322, B22F 10/28, B33Y 10/00, B33Y 30/00

(54) **PROCESS CHAMBER AND METHOD FOR PURGING THE SAME**
PROZESSKAMMER UND VERFAHREN ZUR ENTLÜFTUNG DAVON
CHAMBRE DE TRAITEMENT ET SON PROCÉDÉ DE PURGE

(43) Date of publication of application: 01.05.2019
(73) Proprietor: L'Air Liquide, Société Anonyme pour l'Etude et l'Exploitation des Procédés Georges Claude, 75007 Paris (FR); Air Liquide Deutschland GmbH, 40476 Düsseldorf (DE)
(72) Inventor: Kaya, Cerkez, 47805 Krefeld (DE); Effinger, Markus, 47839 Krefeld (DE)
(74) Representative: Keenway Patentanwälte Neumann Heine Taruttis

(56) References cited:
- KR-A- 20160 146 365
- US-A- 5 565 034
- US-A- 5 908 504
- US-A1- 2001 038 988
- US-A1- 2010 084 094
- US-A1- 2016 284 542
- US-A1- 2017 263 346
- US-B1- 6 323 129

## Description

The present invention is directed to a process chamber and a method for purging the same.

Several processes are performed in an inert atmosphere to suppress undesired chemical reactions. This is the case, for example, in additive manufacturing. The process of additive manufacturing covers several applications. According to some applications, a product is manufactured by providing a precursor powder and by locally and selectively melting the powder, for example by a laser. If this is performed for several powder layers, a product can be obtained. It is desirable to perform the process in a defined atmosphere. The defined atmosphere may have a specific concentration of, for example, oxygen, nitrogen, argon and/or helium and/or may have a specific humidity.

For example, the presence of oxygen, in particular during the melting process step, may impair the quality of the product, in particular as the powder could oxidize. To reduce or avoid this effect, additive manufacturing is commonly performed in an inert atmosphere within a process chamber. For materials such as titanium based alloys also the presence of nitrogen can be disadvantageous.

Also, autoclaves are usually operated with an inert atmosphere. An autoclave is a process chamber that is sealed in an air-tight manner to its environment and that is used, in particular, for thermal and/or chemical treatment of products.

An inert atmosphere within a process chamber can be obtained by purging the process chamber with in inert gas. Therefore, usually the inert gas is introduced into the process chamber, thus displacing and replacing the gas initially contained within the process chamber. However, in particular due to adhesive effects binding oxygen on surfaces of the process chamber in particular small oxygen concentrations in the process chamber can only be reached by purging for rather long purging times. A particularly large amount of the inert gas might be needed for this purpose. For example, in additive manufacturing, purging usually takes up to 40 minutes, wherein a volume of the inert gas is consumed that is equal to - in theory - 2 or 3 times the volume of the process chamber. In practice, even much larger amounts of inert gas are often consumed. In particular, if the process chamber has to be opened frequently between processes and, thus, has to be purged often, a long purging time and a high gas consumption are disadvantageous.

From US 5 565 034 A a substrate processing apparatus is known, wherein nitrogen can be introduced into a furnace. However, thereby no purging with a low purging gas consumption and/or with a short purging time can be achieved.

It is, therefore, an object of the present invention to overcome at least in part the disadvantages known from prior art and, in particular, to provide a process chamber and a method for purging the same, wherein a purging time and/or a consumption of purging gas is particularly low.

These objects are solved by the features of the independent claims. Dependent claims are directed to preferred embodiments of the present invention.

A method for purging a process chamber is provided that comprises the features of claim 1.

The term process chamber is understood to cover any volume suitable for performing a process such as manufacture or treatment of a product placed within the process chamber. Preferably, the process chamber can be sealed in a gas-tight manner such that a predetermined atmosphere is adjustable within the process chamber. The predetermined atmosphere can comprise predetermined concentrations or partial pressures of one or more gases and/or a predetermined overall pressure. Also, the predetermined atmosphere may be a vacuum. In particular, the predetermined atmosphere may be an inert atmosphere, wherein the concentration of oxygen is below a predetermined value. The predetermined atmosphere may comprise argon, helium, hydrogen, nitrogen, oxygen, carbon dioxide, carbon monoxide and/or ammonium, each with a respectively predetermined concentration or predetermined partial pressure. In particular, the predetermined atmosphere may be a mixture of argon and helium, a mixture of hydrogen and nitrogen, a mixture of argon and oxygen, a mixture of argon and nitrogen, a mixture of argon and hydrogen or a mixture of nitrogen and helium.

The process chamber is preferably formed within a housing, for example made with walls of a metal such as steel. The process chamber can have, for example, a cuboid, cubic or cylindrical shape. Preferably, the process chamber comprises at least one door or flap for opening the process chamber allowing to place a product or a precessor (like e. g. precursor powder or a pre-product that is to be treated) thereof into the process chamber and/or for removing the product or its precessor from the process chamber. Also, the process chamber can have an air lock for that purpose. Further, the process chamber preferably comprises at least one port for introducing a gas into the process chamber and/or for removing a gas from the process chamber. In particular via such a port, the predetermined atmosphere can be adjusted within the process chamber. Depending on the densities of the gases that are introduced into the process chamber and that are removed from the process chamber the respective port is preferably arranged at an upper side, a lower side or a lateral side of the process chamber. For example, a plurality of ports can be provided such that a specific process chamber can be used for different gases. Thereby, the port best suitable for introducing a specific gas into the process chamber and/or for removing a specific gas from the process chamber can be used.

With the described method purging can be performed in a particularly fast manner, whereby a particularly low amount of purging gas is consumed. This can be obtained in particular as the temperature of the gas initially contained within the process chamber is increased according to step a). The gas initially contained within the process chamber can be any gas or mixture of gaseous substances that constitutes the starting point for the described method. **In** particular, the gas initially contained in the process chamber can be air. This applies to most cases in practice, as purging of the process chamber is usually performed after the process chamber has been opened, for example, to place a product into the process chamber and/or for removing a product from the process chamber. However, the described method can be used for purging the process chamber irrespective of a composition of the gas initially present within the process chamber.

Purging is supposed to be understood as an exchange of gas contained within the process chamber. For example, by purging air contained initially within the process chamber can be replaced with nitrogen. Subsequently, the process for which the process chamber is intended can be performed within the process chamber. This kind of purging can be considered a static process. The process for which the process chamber is intended is preferably started after the purging has been completed. However, it is also possible to start the process for which the process chamber is intended before the purging is completed.

After such a static purging it is also possible to provide a constant flow of the purging gas through the purging section. This could also be referred to as a continuous purging. A continuous purging can be performed under positive pressure and/or depending on a measured value.

With the described method, a static and/or a continuous purging can be performed. In particular, a static purging can be performed for initially exchanging gases within the process chamber and subsequently a continuous purging can be performed. The process for which the process chamber is intended can be performed in particular during the continuous purging. In particular step b) may be part of a static and/or continuous purging. Also, it is possible to vary a volume of the purging section during continuous purging and/or during performing the process for which the process chamber is intended. In particular, the volume of the purging section can be varied according to a stage of the process for which the process chamber is intended. This way, for example, the volume of a space in which selective laser melting is performed - which can be the purging section, for example - can be increased according to an increase of the volume of a manufactured product.

By increasing the temperature of the gas initially present within the process chamber, the density of this gas is decreased. Preferably, at least one port of the process chamber is opened during or after increasing the temperature according to step a) so that at least a part of the gas initially contained within the process chamber can escape the process chamber as the gas expands due to the increase in temperature. Thus, the total number of gas molecules or gas atoms contained within the process chamber is reduced. This leads to a first reduction of the number of oxygen molecules in the process chamber although the partial pressure of oxygen should not be significantly changed by this step.

As the gas initially contained within the process chamber is supposed to be displaced from the process chamber and replaced by the purging gas, the reduction of the density of the gas initially contained within the process chamber can reduce the purging time and/or the consumption of the purging gas. This is due to the fact that a lower number of gas molecules or gas atoms has to be removed from the process chamber after step a). Furthermore, the number of molecules adsorbed on surfaces in the process chamber is reduced due to the increased temperature.

The purging gas introduced into the process chamber according to step b) is colder than the gas initially contained within the process chamber. Thus, the purging gas is introduced into the process chamber at a relatively higher density as in a case where the purging gas has the same temperature as the gas initially contained within the process chamber.

The larger the difference between the first and second temperature is, the larger is the difference in densities of the gases and the more can the purging time and the purging gas consumption be reduced. The first temperature is preferably at least 20 K, in particular at least 50 K higher than the second temperature.

In a preferred embodiment of the method the purging gas is an inert gas.

With an inert purging gas an inert atmosphere can be obtained within the process chamber. The inert atmosphere can be characterized by an oxygen concentration being below a predetermined value and/or a concentration of the inert gas above a predetermined value. Concentrations of other gases thereby may remain unconsidered. Preferably, the inert gas is nitrogen, helium, argon and/or carbon dioxide.

Alternatively, it is preferred that the purging gas is air.

In a further preferred embodiment of the method the purging is performed at least to such an extent that an oxygen concentration within the process chamber is below 1000 ppm [parts per million] after the purging.

The oxygen concentration allowable after purging can depend on the application. For example, for selective laser melting a concentration of maximally 1000 ppm can be acceptable. For other applications, however, lower oxygen concentrations are preferable. For example, for treating materials such as chromium and/or nickel an oxygen concentration of less than 20 ppm is preferable, for materials such as tantalum an oxygen concentration of less than 5 ppm is preferable. For treating plastic materials even oxygen concentrations of up to 5000 ppm may be acceptable.

In a further preferred embodiment of the method the second temperature is below 0 °C.

The purging time and/or the purging gas consumption can be reduced in particular if not only the temperature of the gas initially contained within the process chamber is increased according to step a), but if also the purging gas is introduced into the process chamber according to step b) at a particularly low temperature. Preferably, the second temperature is even lower than -20°C. In order to prevent damage from the process chamber and/or a product placed therein, the temperature of the process gas is at least above a minimum value. The second temperature is preferably above -30 °C.

In a further preferred embodiment of the method prior to step a) a temperature of the gas initially contained within the process chamber is at least 50 K lower than the first temperature.

Preferably, the temperature of the gas initially contained within the process chamber is at least 75 K lower than the first temperature. In this embodiment, the temperature of the gas initially contained within the process chamber is increased during step a), that is from beginning to end of step a), by at least 40 K, preferably by at least 100 K and in particular even by at least 200 K. This can contribute to a respective difference between the first and second temperatures.

In a further preferred embodiment the method further includes evaporating liquid nitrogen and/or argon prior to step b) and using the evaporated nitrogen and/or argon as the purging gas in step b).

Nitrogen and argon are inert gases that are particularly suitable for many different processes. Also, nitrogen and argon can be easily stored in their liquid states, for example in storage tanks. Prior to using the nitrogen and/or argon in the gaseous state, the nitrogen and/or argon extracted from the storage tank can be evaporated, for example within an evaporator or a heat exchanger for exchanging heat with environmental air or a medium such as water. In particular if evaporated nitrogen and/or argon is used, a particularly low second temperature can be achieved easily. Argon can be used in particular in the treatment of materials such as titanium.

Alternatively, other gases can be used, in particular such gases that can be liquified and stored in their liquid state. Also, mixtures of gases can be used.

According to the present invention at least one of the following parameters
- a flow rate of the purging gas in step b) and
- a purging time, over which step b) is performed,
is controlled depending on at least one of the following parameters:
- a temperature measured within the process chamber and
- an oxygen concentration measured within the process chamber.

This is particularly suitable for obtaining an inert atmosphere within the process chamber.

The flow rate of the purging gas is the amount of the purging gas, in particular a mass or a volume of the purging gas, that is introduced into the process chamber per time. That is, the flow rate can be a mass flow rate or a volume flow rate. The purging time is the total time over which the purging is performed, that is in particular a total time from beginning to end of step b). The higher the flow rate of the purging gas and/or the longer the purging time is, the larger is the amount, in particular the mass, of the purging gas that is introduced in total into the process chamber for purging.

Before purging, the temperature and oxygen concentration within the process chamber are the temperature and oxygen concentration of a gas initially contained within the process chamber. During purging, the temperature and oxygen concentration within the process chamber are the temperature and oxygen concentration of a mixture of the gas initially contained within the process chamber and the purging gas. After purging, the temperature and oxygen concentration within the process chamber are the temperature and oxygen concentration of the purging gas and a potential remainder of the gas initially contained within the process chamber. The temperature and oxygen concentration within the process chamber are preferably measured at least during a part of step a). Additionally, the temperature and oxygen concentration within the process chamber can also be measured during at least a part of step b).

The flow rate of the purging gas and/or the purging time are preferably controlled such that the consumption of the purging gas is as low as achievable. In many applications in particular the purging time is of particular importance. Thus, it is particularly preferred to reduce the purging time. The flow rate of the purging gas and/or the purging time can be controlled as described, for example, by introducing the purging gas only if the temperature within the process chamber is higher than a predetermined threshold value. The threshold value can be predetermined, for example, depending on the elapsed time and/or the oxygen concentration within the process chamber. In particular, the predetermined value can be set to a value equal to or greater than the first temperature.

According to the method the first temperature is determined such that after step b) an oxygen concentration within the process chamber is below a predetermined maximum oxygen concentration if a volume of the purging gas introduced into the process chamber in step b) is a factor of less than 1.5 larger than a total volume of the process chamber.

As an inert atmosphere can be characterized by a maximum oxygen concentration, this embodiment is particularly suitable for obtaining an inert atmosphere within the process chamber.

The higher the first temperature is, the less purging gas has to be introduced into the process chamber. Thus, the first temperature can be chosen such that for a given amount of purging gas available for purging, the oxygen concentration is reduced below the predetermined maximum oxygen concentration. In this embodiment, the amount of purging gas that can be used is set to be maximally 1.5 times the total volume of the process chamber. Therein, the volume is supposed to be determined at the actual temperature and the actual pressure of the purging gas. Should the temperature and/or the pressure of the purging gas vary during purging, respective mean values are supposed to be considered.

The total volume of the process chamber is defined as the volume that is to be purged. That is, any subspaces that are attached to the purging chamber or that form part thereof are included in the total volume of the process chamber only if gas from the (main) process chamber can access such subspaces. For example, the volume of a powder storage that is connected to the process chamber is included in the total volume of the process chamber only if the connection is configured such that gas from the process chamber can access the powder storage such that the powder storage has to be purged jointly with the process chamber.

A dependence of the oxygen concentration reached after purging over a certain purging time and with a certain flow rate of the purging gas from the first temperature can be determined experimentally, in particular for different purging times and/or different flow rates of the purging gas. The obtained dependence can, for example, be stored as a look-up table in a control unit of the process chamber.

In a further preferred embodiment of the method the first temperature is determined such that after step b) an oxygen concentration within the process chamber is below a predetermined maximum oxygen concentration if a purging time, over which step b) is performed, is less than 5 minutes.

Similar to the previous embodiment, the present embodiment is particularly suitable for obtaining an inert atmosphere within the process chamber. Here, it is the purging time that is addressed. A total amount of the purging gas that is introduced into the process chamber is determined by the flow rate at which the purging gas is introduced into the process chamber and the total time of purging (purging time). In particular, the amount of the purging gas, in particular the mass or the volume of the purging gas, can be obtained as a time integral of the mass flow rate or the volume flow rate, respectively. Thus, a certain total amount of the purging gas and a certain flow rate of the purging gas correspond to a respective purging time. Thus, the purging time requirement corresponds to a certain combination of the total amount of the purging gas and the flow rate of the purging gas, which in turn correspond to a certain first temperature.

A dependence of the oxygen concentration reached after purging with a certain flow rate of the purging gas from the first temperature can be determined experimentally, in particular for different flow rates of the purging gas. The obtained dependence can, for example, be stored as a look-up table in a control unit of the process chamber.

According to a further aspect of the present invention a method is provided that comprises manufacturing a three-dimensional product within a process chamber by way of additive manufacturing after the process chamber has been purged by the described method.

The details and advantages disclosed for the method for purging the process chamber can be applied to the present method, and vice versa.

Additive manufacturing can be performed in order to manufacture three dimensional products. Thereby, the material of the product is provided as a powder within the process chamber. The powder thus can be referred to as a precursor material. By locally heating up the precursor powder, for example by a laser, the powder can be molten and thus transformed into solid material locally. If this is performed for several powder layers, the product can be obtained layer by layer.

Additive manufacturing is preferably performed in an inert atmosphere. This can prevent oxidization of the powder and/or the product. Also, residual powder and fumes can be removed from the powder layer surface by a flow of the inert gas. The inert gas can also prevent or at least reduce deposition of fumes and spatters on the powder.

As a further aspect a method is provided that comprises using a process chamber as an autoclave after the process chamber has been purged by the described method.

The details and advantages disclosed for the method for purging the process chamber can be applied to the present method, and vice versa.

An autoclave is a process chamber that can be sealed in a gas-tight manner and that can be used, in particular, for thermal and/or chemical treatment of a product. Such thermal treatment is preferably performed in an inert atmosphere to avoid oxidization of the treated product.

In particular in an autoclave a predetermined atmosphere comprising ammonium can be used.

As a further aspect a control unit is provided that is configured for performing any of the described methods.

The details and advantages disclosed for the described methods can be applied to the control unit, and vice versa.

The control unit is preferably connected to at least one pressure sensor, at least one temperature sensor and/or at least one sensor for measuring gas concentrations, in particular an oxygen concentration within the process chamber.

As a further aspect a process chamber according to claim 10 is provided.

The details and advantages disclosed for the described methods can be applied to the process chamber, and vice versa.

The process chamber is configured for performing the described method for purging the process chamber, the described method comprising manufacturing a three-dimensional product within the process chamber by way of additive manufacturing and/or the described method comprising using the process chamber as an autoclave. The heater can be, for example, an electric heater, particularly a heating coil, within the process chamber.

It should be noted that the individual features specified in the claims may be combined with one another in any desired technological reasonable manner and form further embodiments of the invention. The specification, in particular taken together with the figures, explains the invention further and specifies particularly preferred embodiments of the invention. Particularly preferred variants of the invention and the technical field will now be explained in more detail with reference to the enclosed figures. It should be noted that the exemplary embodiment shown in the figures is not intended to restrict the invention. The figures are schematic and may not be to scale. The figures display:
Fig. 1: a schematic view of a first embodiment of a process chamber;
Fig. 2: a schematic view of a second embodiment of a process chamber;
Fig. 3: a schematic view of a third embodiment of a process chamber; and
Fig. 4: a schematic view of a method for purging the process chamber of either of fig. 1 to 3.

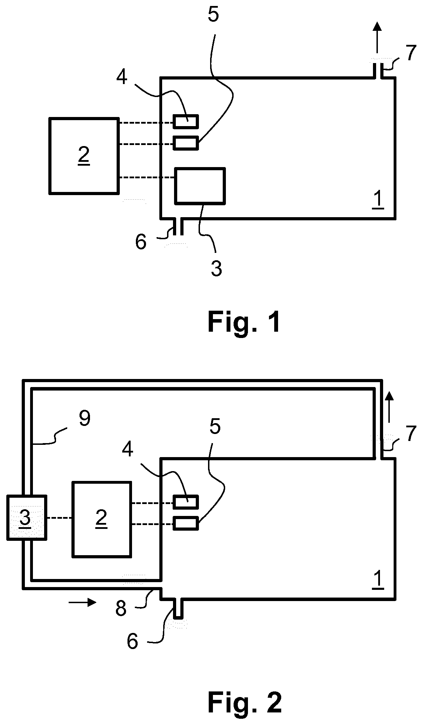

Fig. 1 shows a first embodiment of a process chamber 1 with a control unit 2 that is connected to a heater 3, a temperature sensor 4 and an oxygen sensor 5. The process chamber 1 comprises a first port 6 and a second port 7. During heating the process chamber 1 by the heater 3 gas contained within the process chamber 1 can exhaust via the second port 7 while the first port 6 is closed.

Fig. 2 shows a second embodiment of a process chamber 1. Here, in contrast to fig. 1, the heater 3 is provided within a connection line 9 between a third port 8 and the first port 7. By circulating the gas through the connection line 6 and the process chamber 1 as indicated by an arrow, the gas contained within the process chamber 1 can be heated by the heater 3. Therefore, the heater 3 is preferably embodied as a circulation heater.

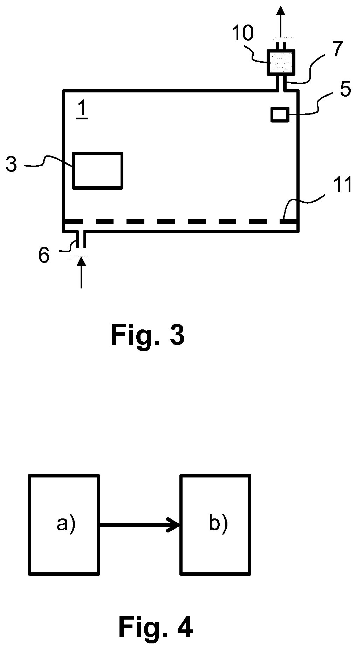

Fig. 3 shows a third embodiment of a process chamber 1. Here, only the oxygen sensor 5 and the heater 3 are shown. Gas can be introduced into the process chamber 1 via the first port 6, whereas exhaust of gas from the process chamber 1 via the second port 7 can be controlled by a valve 10. Also, a distributing element 11 made of a sinter material and/or a tissue is provided within the process chamber 1. The gas introduced into the process chamber 1 via the first port 6 can penetrate through the distributing element 11. The distributing element 11 is shaped such that it improves the distribution of the gas entering the process chamber 1. In particular, the distributing element 11 is adapted based on the geometry, size of and/or flow velocity distribution of gas within the process chamber 1 ensuring a distribution of the gas being adapted to the process chamber 1.

The process chamber 1 of either of fig. 1 to 3 can be purged according to a method depicted in fig. 4, which comprises the following steps:
a) increasing a temperature of a gas initially contained in the process chamber 1 at least to a first temperature,
b) introducing a purging gas, which is at a second temperature, into the process chamber 1, wherein the first temperature is higher than the second temperature, which is below 0 °C.

The purging gas is provided by evaporating liquid nitrogen and/or argon prior to step b) and using the evaporated nitrogen and/or argon as the purging gas in step b). Nitrogen and argon are inert gases.

Step b) is performed at least to such an extent that an oxygen concentration within the process chamber 1 is below 1000 ppm [parts per million] after step b).

At least one of the following parameters
- a flow rate of the purging gas in step b) and
- a purging time, over which step b) is performed,
is controlled depending on at least one of the following parameters:
- a temperature measured by the temperature sensor 4 (shown only in fig. 1 and 2) within the process chamber 1 and
- an oxygen concentration measured by the oxygen sensor 5 within the process chamber 1.

The first temperature is determined such that after step b) an oxygen concentration within the process chamber 1 is below a predetermined maximum oxygen concentration if a volume of the purging gas introduced into the process chamber 1 in step b) is a factor of less than 1.5 larger than a total volume of the process chamber 1 and/or if a purging time, during which step b) is performed, is less than 5 minutes.

After the process chamber 1 has been purged according to the method depicted in fig. 2, the process chamber 1 can be used in particular for manufacturing a three-dimensional product by way of additive manufacturing or as an autoclave.

With the provided method a process chamber 1 can be purged with a purging gas such as nitrogen and/or argon at a particularly low consumption of the purging gas and/or with a particularly short purging time. This can be achieved by increasing the temperature of the gas initially contained within the process chamber 1 prior to purging, thus reducing the density of this gas.

### List of reference numerals

- 1: process chamber
- 2: control unit
- 3: heater
- 4: temperature sensor
- 5: oxygen sensor
- 6: first port
- 7: second port
- 8: third port
- 9: connection line
- 10: valve
- 11: distributing element

## Claims

1. Method for purging a process chamber (1) comprising at least the following steps:
a) increasing a temperature of a gas initially contained in the process chamber (1) at least to a first temperature, thereafter
b) introducing a purging gas, which is at a second temperature, into the process chamber (1), wherein the first temperature is higher than the second temperature,
wherein at least one of the following parameters
- a flow rate of the purging gas in step b) and
- a purging time, over which step b) is performed,
is controlled depending on at least one of the following parameters:
- a temperature measured within the process chamber (1) and
- an oxygen concentration measured within the process chamber (1),
wherein the first temperature is determined such that after step b) an oxygen concentration within the process chamber (1) is below a predetermined maximum oxygen concentration if a volume of the purging gas introduced into the process chamber (1) in step b) is a factor of less than 1.5 larger than a total volume of the process chamber (1).

2. Method according to claim 1, wherein the purging gas is an inert gas.

3. Method according to any of the preceding claims, wherein the second temperature is below 0 °C.

4. Method according to any of the preceding claims, wherein prior to step a) a temperature of the gas initially contained within the process chamber (1) is at least 50 K lower than the first temperature.

5. Method according to any of the preceding claims, further including evaporating liquid nitrogen and/or argon prior to step b) and using the evaporated nitrogen and/or argon as the purging gas in step b).

6. Method according to any of the preceding claims, wherein the purging is performed at least to such an extent that an oxygen concentration within the process chamber (1) is below 1000 ppm [parts per million] after the purging.

7. Method according to any of the preceding claims, wherein the first temperature is determined such that after step b) an oxygen concentration within the process chamber (1) is below a predetermined maximum oxygen concentration if a purging time, over which step b) is performed, is less than 5 minutes.

8. Method comprising manufacturing a three-dimensional product within a process chamber (1) by way of additive manufacturing after the process chamber (1) has been purged by a method according to any of the preceding claims.

9. Method comprising using a process chamber (1) as an autoclave after the process chamber (1) has been purged by a method according to any of the claims 1 to 7.

10. Process chamber (1) comprising at least a heater (3) for increasing the temperature within the process chamber (1) and a control unit (2) for measuring and controlling a temperature within the process chamber (1) and/or a flow rate of a purging gas at least during purging, wherein the process chamber (1) is configured for performing a method for purging the process chamber (1), the method comprising at least the following steps:
a) increasing a temperature of a gas initially contained in the process chamber (1) at least to a first temperature, thereafter
b) introducing a purging gas, which is at a second temperature, into the process chamber (1), wherein the first temperature is higher than the second temperature,
wherein the control unit (2) is configured to control at least one of the following parameters
- a flow rate of the purging gas in step b) and
- a purging time, over which step b) is performed,
depending on at least one of the following parameters:
- a temperature measured within the process chamber (1) and
- an oxygen concentration measured within the process chamber (1),
wherein the first temperature is determined by the control unit (2) such that after step b) an oxygen concentration within the process chamber (1) is below a predetermined maximum oxygen concentration if a volume of the purging gas introduced into the process chamber (1) in step b) is a factor of less than 1.5 larger than a total volume of the process chamber (1).

## Patentansprüche

1. Verfahren zum Entlüften einer Prozesskammer (1), das mindestens die folgenden Schritte umfasst:
a) Erhöhen einer Temperatur eines anfänglich in der Prozesskammer (1) enthaltenen Gases mindestens auf eine erste Temperatur, danach
b) Einleiten eines Entlüftungsgases, das auf einer zweiten Temperatur ist, in die Prozesskammer (1), wobei die erste Temperatur höher ist als die zweite Temperatur,
wobei mindestens einer der folgenden Parameter
- eine Strömungsgeschwindigkeit des Entlüftungsgases in Schritt b) und
- eine Entlüftungsdauer, in der Schritt b) durchgeführt wird,
in Abhängigkeit von mindestens einem der folgenden Parameter gesteuert wird:
- einer Temperatur, die innerhalb der Prozesskammer (1) gemessen wird, und
- einer in der Prozesskammer (1) gemessenen Sauerstoffkonzentration,
wobei die erste Temperatur so bestimmt wird, dass nach Schritt b) eine Sauerstoffkonzentration innerhalb der Prozesskammer (1) unter einer vorbestimmten maximalen Sauerstoffkonzentration liegt, wenn ein Volumen des in Schritt b) in die Prozesskammer (1) eingeleiteten Entlüftungsgases um einen Faktor von weniger als 1,5 größer ist als ein Gesamtvolumen der Prozesskammer (1).

2. Verfahren nach Anspruch 1, wobei das Entlüftungsgas ein Inertgas ist.

3. Verfahren nach einem der vorhergehenden Ansprüche, wobei die zweite Temperatur unter 0 °C liegt.

4. Verfahren nach einem der vorhergehenden Ansprüche, wobei vor Schritt a) eine Temperatur des Gases, das anfänglich in der Prozesskammer (1) enthalten ist, mindestens 50 K niedriger ist als die erste Temperatur.

5. Verfahren nach einem der vorhergehenden Ansprüche, das ferner Verdampfen von flüssigem Stickstoff und/oder Argon vor Schritt b) und Verwenden des verdampften Stickstoffs und/oder Argons als Entlüftungsgas in Schritt b) umfasst.

6. Verfahren nach einem der vorhergehenden Ansprüche, wobei das Entlüften zumindest so weit durchgeführt wird, dass eine Sauerstoffkonzentration innerhalb der Prozesskammer (1) nach dem Entlüften unter 1000 ppm [parts per million] liegt.

7. Verfahren nach einem der vorhergehenden Ansprüche, wobei die erste Temperatur so bestimmt wird, dass nach Schritt b) eine Sauerstoffkonzentration innerhalb der Prozesskammer (1) unter einer vorbestimmten maximalen Sauerstoffkonzentration liegt, wenn eine Entlüftungsdauer, in der Schritt b) durchgeführt wird, weniger als 5 Minuten beträgt.

8. Verfahren, das die Herstellung eines dreidimensionalen Erzeugnisses in einer Prozesskammer (1) mittels additiver Herstellung umfasst, nachdem die Prozesskammer (1) durch ein Verfahren nach einem der vorhergehenden Ansprüche entlüftet wurde.

9. Verfahren, das das Verwenden einer Prozesskammer (1) als einen Autoklaven umfasst, nachdem die Prozesskammer (1) durch ein Verfahren nach einem der Ansprüche 1 bis 7 entlüftet wurde.

10. Prozesskammer (1), die mindestens eine Heizung (3) zum Erhöhen der Temperatur innerhalb der Prozesskammer (1) und eine Steuereinheit (2) zum Messen und Steuern einer Temperatur innerhalb der Prozesskammer (1) und/oder einer Strömungsgeschwindigkeit eines Entlüftungsgases mindestens beim Entlüften umfasst, wobei die Prozesskammer (1) zum Durchführen eines Verfahrens zum Entlüften der Prozesskammer (1) ausgelegt ist, wobei das Verfahren mindestens die folgenden Schritte umfasst:
a) Erhöhen einer Temperatur eines anfänglich in der Prozesskammer (1) enthaltenen Gases mindestens auf eine erste Temperatur, danach
b) Einleiten eines Entlüftungsgases, das auf einer zweiten Temperatur ist, in die Prozesskammer (1), wobei die erste Temperatur höher ist als die zweite Temperatur,
wobei die Steuereinheit (2) dazu ausgelegt ist, mindestens einen der folgenden Parameter zu steuern
- eine Strömungsgeschwindigkeit des Entlüftungsgases in Schritt b) und
- eine Entlüftungsdauer, in der Schritt b) durchgeführt wird,
in Abhängigkeit von mindestens einem der folgenden Parameter:
- einer Temperatur, die innerhalb der Prozesskammer (1) gemessen wird, und
- einer in der Prozesskammer (1) gemessenen Sauerstoffkonzentration,
wobei die erste Temperatur durch die Steuereinheit (2) so bestimmt wird, dass nach Schritt b) eine Sauerstoffkonzentration innerhalb der Prozesskammer (1) unter einer vorbestimmten maximalen Sauerstoffkonzentration liegt, wenn ein Volumen des in Schritt b) in die Prozesskammer (1) eingeleiteten Entlüftungsgases um einen Faktor von weniger als 1,5 größer ist als ein Gesamtvolumen der Prozesskammer (1).

## Revendications

1. Procédé pour purger une chambre de traitement (1) comprenant au moins les étapes suivantes :
a) augmentation d'une température d'un gaz initialement contenu dans la chambre de traitement (1) au moins jusqu'à une première température, puis
b) introduction d'un gaz de purge qui est à une seconde température dans la chambre de traitement (1), dans lequel la première température est supérieure à la seconde température,
dans lequel au moins un des paramètres suivants
- un débit du gaz de purge à l'étape b) et
- un temps de purge pendant lequel on réalise l'étape b),
est régulé en fonction d'au moins un des paramètres suivants :
- une température mesurée au sein de la chambre de traitement (1) et
- une concentration en oxygène mesurée au sein de la chambre de traitement (1),
dans lequel la première température est déterminée de telle sorte qu'après l'étape b), une concentration d'oxygène dans la chambre de traitement (1) soit inférieure à une concentration d'oxygène maximale prédéterminée si un volume du gaz de purge introduit dans la chambre de traitement (1) dans l'étape b) est d'un facteur inférieur à 1,5 supérieur à un volume total de la chambre de traitement (1).

2. Procédé selon la revendication 1, dans lequel le gaz de purge est un gaz inerte.

3. Procédé selon l'une quelconque des revendications précédentes, dans lequel la seconde température est inférieure à 0 °C.

4. Procédé selon l'une quelconque des revendications précédentes, dans lequel, avant l'étape a), une température du gaz initialement contenu dans la chambre de traitement (1) est inférieure d'au moins 50 K à la première température.

5. Procédé selon l'une quelconque des revendications précédentes, comprenant en outre l'évaporation d'azote et/ou d'argon liquide avant l'étape b) et l'utilisation de l'azote et/ou de l'argon évaporé(s) comme gaz de purge dans l'étape b).

6. Procédé selon l'une quelconque des revendications précédentes, dans lequel la purge est effectuée au moins dans une mesure telle qu'une concentration d'oxygène à l'intérieur de la chambre de traitement (1) soit inférieure à 1 000 ppm [parties par million] après la purge.

7. Procédé selon l'une quelconque des revendications précédentes, dans lequel la première température est déterminée de telle sorte qu'après l'étape b), une concentration d'oxygène à l'intérieur de la chambre de traitement (1) soit inférieure à une concentration d'oxygène maximale prédéterminée si un temps de purge, pendant lequel l'étape b) est effectuée, est inférieur à 5 minutes.

8. Procédé, comprenant la fabrication d'un produit tridimensionnel à l'intérieur d'une chambre de traitement (1) par le biais de fabrication additive après que la chambre de traitement (1) a été purgée par l'intermédiaire d'un procédé selon l'une quelconque des revendications précédentes.

9. Procédé, comprenant l'utilisation d'une chambre de traitement (1) en tant qu'autoclave après que la chambre de traitement (1) a été purgée par l'intermédiaire d'un procédé selon l'une quelconque des revendications 1 à 7.

10. Chambre de traitement (1) comprenant au moins un dispositif de chauffage (3) pour augmenter la température dans la chambre de traitement (1) et une unité de commande (2) pour mesurer et réguler une température dans la chambre de traitement (1) et/ou un débit d'un gaz de purge au moins pendant la purge, la chambre de traitement (1) étant configurée pour exécuter un procédé de purge de la chambre de traitement (1), le procédé comprenant au moins les étapes suivantes :
a) augmentation d'une température d'un gaz initialement contenu dans la chambre de traitement (1) au moins jusqu'à une première température, puis
b) introduction d'un gaz de purge qui est à une seconde température dans la chambre de traitement (1), dans lequel la première température est supérieure à la seconde température,
dans laquelle l'unité de commande (2) est configurée pour réguler au moins un des paramètres suivants
- un débit du gaz de purge à l'étape b) et
- un temps de purge pendant lequel on réalise l'étape b),
en fonction d'au moins un des paramètres suivants :
- une température mesurée au sein de la chambre de traitement (1) et
- une concentration en oxygène mesurée au sein de la chambre de traitement (1),
dans lequel la première température est déterminée par l'unité de commande (2) de sorte qu'après l'étape b), une concentration d'oxygène dans la chambre de traitement (1) soit inférieure à une concentration d'oxygène maximale prédéterminée si un volume du gaz de purge introduit dans la chambre de traitement (1) à l'étape b) est d'un facteur inférieur à 1,5 supérieur à un volume total de la chambre de traitement (1).
